# EUROPEAN PATENT SPECIFICATION

(11) **EP 1 705 490 B1**
(45) Date of publication and mention of the grant of the patent: **21.04.2010**
(21) Application number: 06468002.8
(22) Date of filing: 17.03.2006
(51) Int. Cl.: G01R 31/07, H01H 85/30

(54) **Method for estimating the adequacy of protective devices**
Verfahren zur Bestimmung der Eignung von Schutzvorrichtungen
Procédé d'estimation de l'exactitude des dispositifs de protection

(30) Priority: 21.03.2005 SI 200500069
(43) Date of publication of application: 27.09.2006
(73) Proprietor: Metrel, Merilna, 1354 Horjul (SI)
(72) Inventor: Guzelj, Janez, 1356 Dobrova (SI)
(74) Representative: Flak, Antonija

(56) References cited:
- DE-A1- 4 022 658
- US-A1- 2002 032 619
- US-A1- 2002 163 343

## Description

### Filed of the invention

This invention appertains to the field of electrical measuring devices, more precisely to the field of electrical installation resistance or impedance meters, which are supplemented with a composition for estimation of adequacy of protective device in line or fault loop, which is a subject of measurement.

### Technical problem

Technical problem that is solved with this invention is design of the method that will make possible comparison between parameters of protective device data from inscribed list of standard protective devices with their characteristics, and measured characteristics of electrical grid, that would be indicated as results on display of the electrical instrument. The composition shall also enable saving results into memory for easy inspection of all measured conductors by operator. This means that the access to estimation of the adequacy of protective devices in electrical grid (quality of electrical installation) in regard to the requirements will be simplified and reliable.
Technical problem is how to build and use the fuse list for deciding about the adequacy of the fuse that is actually built in the installation. The fuse is normally defined by designer of tested electrical installation, which means that the operator uses the type that is prescribed, or uses data from the fuse that is actually built in the fuse board.

### Background to the disclosure

Various electrical installation testers exist on the market with line or fault loop impedance or resistance measuring function alone or in combination with other functions. Line impedance is internal impedance of electrical grid that is measured between line and neutral conductors or between two line conductors on the tested wall socket or connection device. Fault loot impedance is internal impedance of electrical grid that is measured between line and protect earth (PE) conductors on the tested wall socket or connection device. Electrical installation must be safe. Conductors heat when carrying high current and this could lead softening their insulation to short circuits and burning of the object supplied with electrical energy. For this reason to prevent the damage, the protective devices that timely disconnect overloaded circuit are applied. Protective devices are fuses (in the most cases) and other types of electromechanical circuit breakers. For testing the electrical installation at present, the operator has to measure impedance (or resistance) of each connection (wall socket) to the electrical grid, calculate short circuit current that would flow (modern instruments can already do this automatically) and then make comparison with data of the protective device that will be or is built in tested electrical installation. The operator has to compare received result with data by his feeling or searching through the papers. The operator has also possibility to make comparison after transferring results to a computer with those that are stored in the computer. Those methods require more attention of the operator and does not deliver optimal reliability of reading and estimating results, they are also time consuming.

Inventor knows the solution of GMC - Gossen-Metrawatt, their instruments make possibility as a resource for operator, to display useful fuses (protective devices) regarding the measured impedance. GMC instruments have, after a key is pressed, the possibility to display the list of applicable fuses which breaking current is lower, but close to the received short circuit current.

Patent DE0422658A1 relates to marking safetly fuses, which also enables automatic reading of already build in fuses and by that comparison to regulation specifications.

Patent application US2002/0032619A1 relates to a web-based method for identifying fuses which incluides receiving fuse specification information from a user and utilizing a server to compare the received specification information with pre-stored information. The method also includes selecting at least one fuse, which matches to the received specification information and downloading information related to the received specification information and downloading information related to the user. This invention relates to web-based finder of fuses produced by firm GE Industrial System, which can find an appropriate selection of their fuse in respect of choosing specifications.

Both patent applications are related to automatic identification of protective devices, the first one for automatic verification if proper is installed by detection of its marking, and the second one for selection of the protective device according to required characteristics. Nor first nor second covers the technical problem of invented solution.

### Description of the invention

The essence of method for estimation of adequacy of protective devices is that the operator selects data of protective device; makes measurement and the meter will report suitability of selected protective device beside the impedance or resistance and short circuit current results. The result that can be stored can contain besides the measured results and selected protective device data also decision of suitability of the protective device. Stored values are intended for later inspection and for creating a report of inspection and testing of the electrical installations. The method for comparing and indicating measured values of particular electrical line and the closest characteristics of standard fuses according to this invention, is **characterized in that** the instrument based on selected fuse from fuse list indicates after the measurement if the protective device is suitable or not.

Description of the method according to the invention that follows is supported by figures, which shows:
Figure 1 - block diagram of the method according to the invention
Figure 2 - block diagram of the method according to the first application example

Execution of the method for estimating adequacy of protective devices according to the invention is made possible by micro controller in the tester of electrical grid resistance or impedance. Protective devices have the following characteristics: type, rated current and breaking current, i.e. the highest current that is required for the protective device to disconnect protected circuit in defined period. These characteristics are defined in standards for various intentions of protection. A short-circuit current i.e. the lowest one that could flow in tested mains and the highest breaking current of protective device are required for comparison for estimation of adequacy of the tested grid or built in protective device. The lowest short circuit current must be higher than the highest breaking current of the protective device.

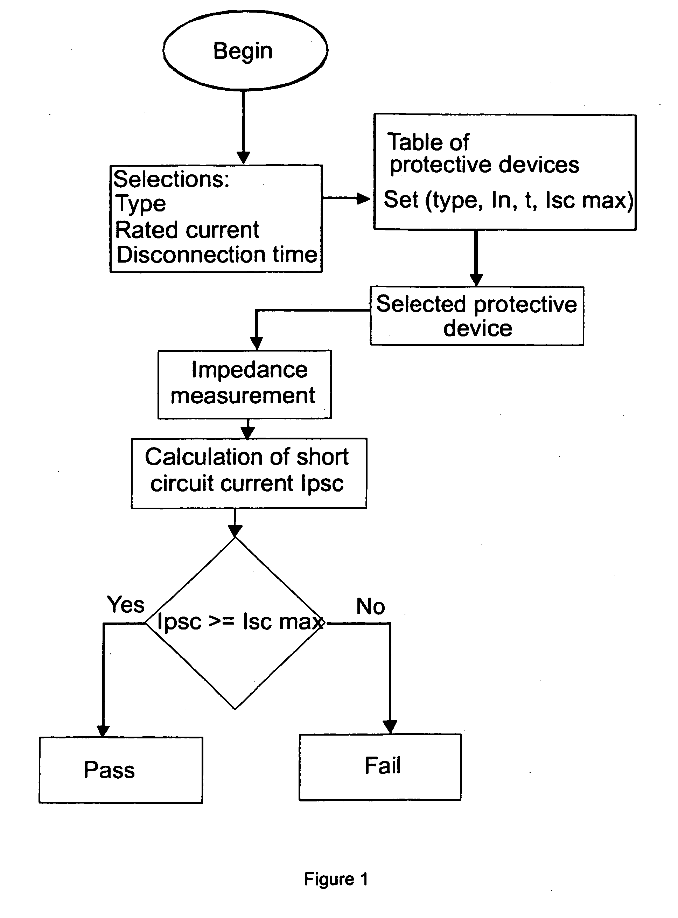

A table of standard fuses (including their characteristics) is written in the memory of electrical grid impedance or resistance meter. As is shown on figure 1, the method is initiated when the operator begins inspecting either planned or built in protective device (type, rated current) and selecting its data in the tester, including the required disconnecting time. The protective device from the table of protective devices is selected with this procedure. Then the operator starts the measurement. The micro controller performs measurement of impedance or resistance, calculates short-circuit current and compares this short-circuit current with breaking current of the selected protective device, and indicates suitability of the selected protective device on display. The method also makes possible to store data of measurement results, the selected protective device and the decision result about suitability of the device. This method of invention makes possible for simple usage of stored data for preparing report about performed inspection and measurements on electrical installations.

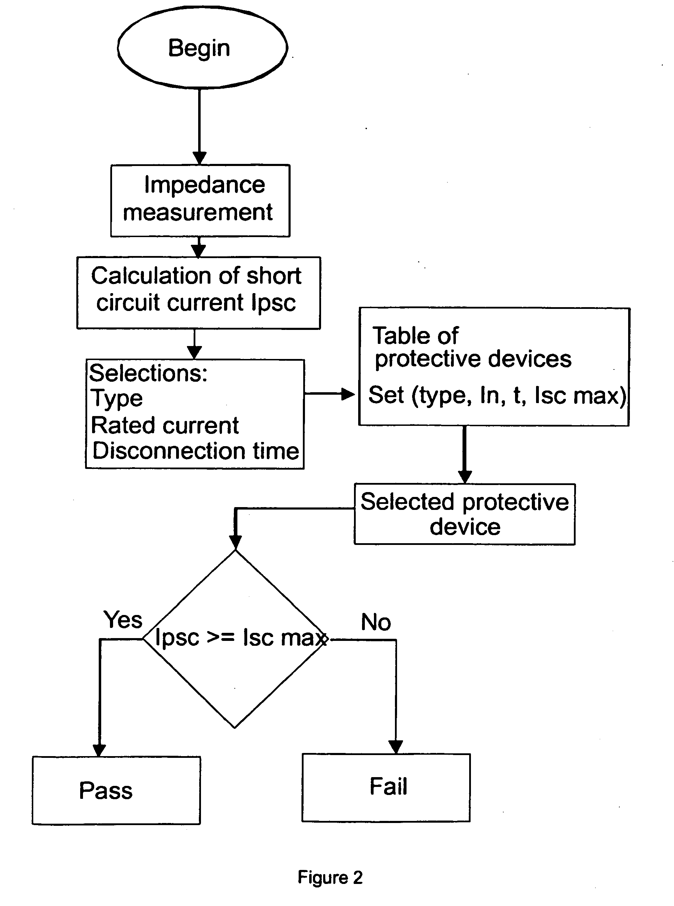

The method of the invention that is described in previous text also makes possible that the operator selects the fuse after the measurement instead before and the instrument indicates suitability of the selected one. As is shown on figure 2, the method of the first realization example begins when the operator of the instrument starts the measurement. Micro controller performs impedance or resistance measurement, calculates short-circuit current and indicates results of measured impedance and short-circuit current. In this step, the operator selects inspected fuse and micro-controller verifies suitability of selected protective device and indicates result as pass / fail (good / bad).

The method presented in the figure 2 enables reselection of the protective device from method of the figure 1. This method for estimating adequacy of protective devices adds new attribute to electrical grid impedance meter. This really finalizes the intention of the function for measuring impedance or resistance in electrical grid, with which the operator approves technical suitability of the tested installation.

## Claims

1. Method for estimating the adequacy of a selected grid protective device using an electrical grid impedance or resistance meter, in which the electrical grid impedance or resistance meter comprises a memory, a micro controller and a display, the method comprises the steps of:
- selecting, by the operator, a grid protective device from a table of standard grid protective devices, where the table of standard grid protective devices is in the memory of the electrical grid impedance or resistance meter,
- measuring, using the grid impedance or resistance meter, a planned or an already built-in grid protective device,
- comparing, using the micro controller of the grid impedance or resistance meter, the measured grid protective device with the characteristics of the selected protective device,
- estimating, using the micro controller of the grid impedance or resistance meter, the suitability of the selected grid protective device based on the comparison between the measured grid protective device and the characteristics of the selected protective device,
- indicating, using the display of the grid impedance or resistance meter, the suitability of the selected grid protective device.

2. Method for estimating the adequacy of a selected grid protective device using an electrical grid impedance or resistance meter, in which the electrical grid impedance or resistance meter comprises a memory, a micro controller and a display, the method comprises the steps of:
- measuring, using the grid impedance or resistance meter, a planned or an already built-in grid protective device,
- selecting, by the operator, a grid protective device from a table of standard grid protective devices, where the table of standard grid protective devices is in the memory of the electrical grid impedance or resistance meter,
- comparing, using the micro controller of the grid impedance or resistance meter, the measured grid protective device with the characteristics of the selected protective device,
- estimating, using the micro controller of the grid impedance or resistance meter, the suitability of the selected grid protective device based on the comparison between the measured grid protective device and the characteristics of the selected protective device,
- indicating, using the display of the grid impedance or resistance meter, the suitability of the selected grid protective device.

3. Method for estimation of adequacy of protective devices according to the claim 1 **characterized in that** the operator can test the suitability of protective device related to the measured values with selection of the device after measuring, using the grid impedance or resistance meter, the planed or the already built-in grid protective device.

## Patentansprüche

1. Verfahren zur Bestimmung der Eignung einer ausgewählten Netzschutzvorrichtung unter Anwendung eines elektrischen Netzimpedanz- oder Netzwiderstandsmessgeräts, worin das Netzimpedanz- oder Netzwiderstandsmessgerät einen Speicher, einen Mikrocontroller und eine Anzeigevorrichtung umfasst, und das Verfahren die folgenden Schritte umfasst:
- Auswahl von einem Bediener einer Netzschutzvorrichtung aus einer sich im Speicher des elektrischen Netzimpedanz- oder Netzwiderstandsmessgeräts befindenden Tabelle von herkömmlichen Netzschutzvorrichtungen,
- Messung, unter Anwendung des Netzimpedanz- oder Netzwiderstandsmessgeräts, einer beabsichtigten oder schon eingebauten Netzschutzvorrichtung,
- Vergleich, unter Anwendung von Mikrocontroller des Netzimpedanz- oder Netzwiderstandsmessgeräts, der abgemessenen Netzschutzvorrichtung mit den Merkmalen der ausgewählten Schutzvorrichtung,
- Abschätzen, unter Anwendung von Mikrocontroller des Netzimpedanz- oder Netzwiderstandsmessgeräts, die Eignung der ausgewählten Netzschutzvorrichtung auf Grund des Vergleichs zwischen der abgemessenen Netzschutzvorrichtung und den Merkmalen der ausgewählten Netzschutzvorrichtung,
- Anzeigen, unter Anwendung von Netzimpedanz- oder Netzwiderstandsmessgeräts, die Eignung der ausgewählten Netzschutzvorrichtung.

2. Verfahren zur Bestimmung der Eignung einer ausgewählten Netzschutzvorrichtung unter Anwendung eines elektrischen Netzimpedanz- oder Netzwiderstandsmessgeräts, worin das Netzimpedanz- oder Netzwiderstandsmessgerät einen Speicher, einen Mikrocontroller und eine Anzeigevorrichtung umfasst, und das Verfahren die folgenden Schritte umfasst:
- Messung, unter Anwendung des Netzimpedanz- oder Netzwiderstandsmessgeräts, einer beabsichtigten oder schon eingebauten Netzschutzvorrichtung,
- Auswahl von einem Bediener einer Netzschutzvorrichtung aus einer sich im Speicher des elektrischen Netzimpedanz- oder Netzwiderstandsmessgeräts befindenden Tabelle von herkömmlichen Netzschutzvorrichtungen,
- Vergleich, unter Anwendung von Mikrocontroller des Netzimpedanz- oder Netzwiderstandsmessgeräts, der abgemessenen Netzschutzvorrichtung mit den Merkmalen der ausgewählten Schutzvorrichtung,
- Abschätzen, unter Anwendung von Mikrocontroller des Netzimpedanz- oder Netzwiderstandsmessgeräts, die Eignung der ausgewählten Netzschutzvorrichtung auf Grund des Vergleichs zwischen der abgemessenen Netzschutzvorrichtung und den Merkmalen der ausgewählten Netzschutzvorrichtung,
- Anzeigen, unter Anwendung von Netzimpedanz- oder Netzwiderstandsmessgeräts, die Eignung der ausgewählten Netzschutzvorrichtung.

3. Verfahren zur Bestimmung der Eignung von Netzschutzvorrichtungen nach Anspruch 1, **dadurch gekennzeichnet, dass** der Bediener die Eignung der Schutzvorrichtung prüfen kann in Hinsicht auf die gemessenen Werte mit der Auswahl der Vorrichtung nach Abmessung - unter Anwendung des Netzimpedanz- oder Netzwiderstandsmessgeräts - der beabsichtigten oder schon eingebauten Netzschutzvorrichtung.

## Revendications

1. Procédé d'estimation de l'exactitude des dispositifs de protection en utilisant un mesureur d'impédance ou de résistance du réseau, dans lequel le mesureur d'impédance ou de résistance du réseau comprend une mémoire, un micro-côntroleur et un écran, le procédé comprennant les étapes suivantes:
- sélection, par un opérateur, d'un dispositif de protection du réseau d'un tableau de dispositifs de protection du réseau standard, le tableau de dispositifs de protection du réseau standard se trouvant dans la mémoire du mesureur d'impédance ou de résistance du réseau,
- mesurage, en utilisant le mesureur d'impédance ou de résistance du réseau, d'un dispositif de protection du réseau envisagé ou déjà incorporé,
- comparaison, en utilisant le micro-côntroleur du mesureur d'impédance ou de résistance du réseau, du dispositif de protection du réseau mesuré avec les caractéristiques du dispositif de protection choisi,
- évaluation, en utilisant le micro-côntroleur du mesureur d'impédance ou de résistance du réseau, de l'exactitude du dispositif de protection choisi à base d'une comparaison entre le dispositif de protection mesuré et les caractéristiques du dispositif de protection choisi,
- indication, en utilisant l'écran du mesureur d'impédance ou de résistance du réseau, de l'exactitutde du dispositif de protection choisi.

2. Procédé d'estimation de l'exactitude des dispositifs de protection en utilisant un mesureur d'impédance ou de résistance du réseau, dans lequel le mesureur d'impédance ou de résistance du réseau comprend une mémoire, un micro-côntroleur et un écran, le procédé comprennant les étapes suivantes:
- mesurage, en utilisant le mesureur d'impédance ou de résistance du réseau, d'un dispositif de protection du réseau envisagé ou déjà incorporé,
- sélection, par un opérateur, d'un dispositif de protection du réseau d'un tableau de dispositifs de protection du réseau standard, le tableau de dispositifs de protection du réseau standard se trouvant dans la mémoire du mesureur d'impédance ou de résistance du réseau,
- comparaison, en utilisant le micro-côntroleur du mesureur d'impédance ou de résistance du réseau, du dispositif de protection du réseau mesuré avec les caractéristiques du dispositif de protection choisi,
- évaluation, en utilisant le micro-côntroleur du mesureur d'impédance ou de résistance du réseau, de l'exactitude du dispositif de protection choisi à base d'une comparaison entre le dispositif de protection mesuré et les caractéristiques du dispositif de protection choisi,
- indication, en utilisant l'écran du mesureur d'impédance ou de résistance du réseau, de l'exactitutde du dispositif de protection choisi.

3. Procédé d'estimation de l'exactitude de dispositifs de protection selon la revendication 1, **caractérisé en ce que** l'opérateur peut contrôler l'exactitude du dispositif de protection en relation avec les valeurs mesurées avec la sélection du dispositif après le mesurage - en utilisant un mesureur d'impédance ou de résistance du réseau - du dispositif de protection du réseau envisagé ou déjà incorporé.
